# EUROPEAN PATENT APPLICATION

(11) **EP 4 768 923 A1**
(43) Date of publication of application: **01.07.2026**
(21) Application number: 25208746.5
(22) Date of filing: 15.10.2025
(51) Int. Cl.: G01R 1/073

(54) **PROBE CARD AND METHOD FOR INSPECTING LIGHT EMITTING ELEMENT**

(30) Priority: 27.12.2024 KR 20240198291
(71) Applicant: LG Display Co., Ltd., Seoul, 07336 (KR)
(72) Inventor: KWAK, YongSeok, 10845 Paju-si (KR); YANG, Kiyong, 10845 Paju-si (KR); KIM, Il-Soo, 10845 Paju-si (KR); LEE, SeungJun, 10845 Paju-si (KR)
(74) Representative: Ter Meer Steinmeister & Partner

(57) **Abstract**

A probe card and a method for inspecting a light emitting element are disclosed. In one aspect, the probe card includes a probe substrate, a plurality of piezoelectric elements disposed on one surface of the probe substrate, and a plurality of electrode units disposed on the plurality of piezoelectric elements. Each electrode unit includes a plurality of pin electrodes, and each piezoelectric element of the plurality of piezoelectric elements corresponds one to one with each pin electrode of the plurality of pin electrodes. By applying a voltage to each piezoelectric element, its shape can be deformed to change the Z axis position of the corresponding pin electrode. This allows the probe card to adjust the height of individual pin electrodes for contacting electrodes of light emitting elements on a wafer, enabling accurate electrical inspection even when wafer flatness or electrode positions vary.

## Description

This application claims the priority of Korean Patent Application No. 10-2024-0198291 filed on December 27, 2024, in the Korean Intellectual Property Office, the disclosure of which is incorporated herein by reference.

### BACKGROUND

### Technical Field

The present disclosure relates to a probe card and a method for inspecting a light emitting element using the same, and more particularly, to a probe card which inspects a light emitting element (LED) and a method for inspecting a light emitting element using the same.

### Description of the Related Art

As display devices which are used for a monitor of a computer, a television, or a cellular phone, there are an organic light emitting display device (OLED) which is a self-emitting device and a liquid crystal display device (LCD) which requires a separate light source.

An applicable range of the display device is diversified to personal digital assistants as well as monitors of computers and televisions and a display device with a large display area and a reduced volume and weight is being studied.

Further, in recent years, a display device including an LED is attracting attention as a next generation display device. Since the LED is formed of an inorganic material, rather than an organic material, reliability is excellent so that a lifespan thereof is longer than that of the liquid crystal display device or the organic light emitting display device. Further, the LED has a fast lighting speed, excellent luminous efficiency, and a strong impact resistance so that a stability is excellent and an image having a high luminance can be displayed.

The description provided in the discussion of the related art section should not be assumed to be prior art merely because it is mentioned in or associated with that section. The discussion of the related art section may include information that describes one or more aspects of the subject technology, and the description in this section does not limit the disclosure.

### BRIEF SUMMARY

The disclosure presents a probe card with individually controllable pin electrodes whose Z axis positions can be adjusted using one to one piezoelectric actuators. By applying voltage to each piezoelectric unit or element, its shape deforms and changes the height (also referred to as protruding height or protruding length) of the corresponding pin electrode. This allows compensation for variations in wafer flatness and electrode height across a light emitting element array, enabling accurate electrical inspection even on warped or uneven wafers.

The design includes a deformation transmission mechanism that uses a diaphragm and a fluid layer between the piezoelectric elements and the pin electrodes. When the piezoelectric element deforms, pressure transfers through the fluid to the pin electrodes, allowing smooth vertical movement while reducing mechanical stress and potential damage. The system incorporates multiple insulating, wiring, and elastic layers together with flexible printed circuits to ensure electrical isolation, structural stability, and precise signal routing.

The disclosure also describes a manufacturing method using two temporary substrates, one for the electrode units and wiring and another for the piezoelectric elements and diaphragms. These layers are later bonded, processed, and completed into a compact multilayer structure. With the use of real time Z axis sensing through a three dimensional displacement sensor, the probe card provide automated and accurate wafer inspection without limitations caused by electrode height variations or wafer flatness.

For example, various embodiments of the present disclosure provide a probe card which is capable of inspecting an electrical characteristic of a light emitting element and a method for inspecting a light emitting element using the same.

Various embodiments of the present disclosure provide a probe card which is capable of inspecting a plurality of light emitting elements on a wafer without being restricted to a flatness of the wafer and a method for inspecting a light emitting element using the same.

Various embodiments of the present disclosure provide a probe card which is capable of being contacted with electrodes of a plurality of light emitting elements without being restricted to a Z-axis position deviation of the electrodes of the plurality of light emitting elements and a method for inspecting a light emitting element using the same.

Various embodiments of the present disclosure provide a probe card which changes a Z-axis position of a plurality of pin electrodes and a method for inspecting a light emitting element using the same.

Various embodiments of the present disclosure provide a probe card which minimizes or reduces a damage of a plurality of pin electrodes when a Z-axis position of a plurality of pin electrodes is changed and a method for inspecting a light emitting element using the same.

Technical benefits of the present disclosure are not limited to the above-mentioned benefits, and other benefits, which are not mentioned above, can be clearly understood by those skilled in the art from the following descriptions.

According to an aspect of the present disclosure, a probe card includes a probe substrate; a plurality of piezoelectric units or elements disposed on one surface of the probe substrate; and a plurality of electrode units which is disposed on the plurality of piezoelectric elements and includes a plurality of pin electrodes, and each of the plurality of piezoelectric elements is disposed so as to correspond to each of the plurality of pin electrodes one to one. Accordingly, a Z-axis position of the plurality of pin electrodes may vary using a plurality of piezoelectric elements which has a deformable shape.

According to another aspect of the present disclosure, a method for inspecting a light emitting elements includes contacting a probe card with a light emitting element array including a plurality of light emitting elements; sensing a Z-axis position of a plurality of electrodes of the plurality of light emitting elements; adjusting a Z-axis position of each of a plurality of pin electrodes of the probe card based on the Z-axis position; and inspecting an electrical characteristic of the plurality of light emitting elements by contacting the plurality of pin electrodes of the probe card with the plurality of electrodes of the plurality of light emitting elements, and the adjusting of a Z-axis position of each of a plurality of pin electrodes includes driving each of a plurality of piezoelectric elements disposed on the plurality of pin electrodes.

According to another aspect of the present disclosure, a probe card includes a probe substrate, a plurality of piezoelectric elements disposed on one surface of the probe substrate, and a plurality of electrode units which is disposed on the plurality of piezoelectric elements and includes a plurality of pin electrodes, and each of the plurality of piezoelectric elements is disposed so as to correspond to each of the plurality of pin electrodes one to one.

Each of the plurality of electrode units may further include a first wiring line connected to a first pin electrode among the plurality of pin electrodes, and a second wiring line connected to a second pin electrode among the plurality of pin electrodes, and each of the first pin electrode and the second pin electrode may overlap a different piezoelectric element among the plurality of piezoelectric elements.

Each of the plurality of piezoelectric elements may include a first driving electrode on one surface of the probe substrate, a piezoelectric layer on the first driving electrode, a second driving electrode on the piezoelectric layer, and a diaphragm on the second driving electrode.

The probe substrate and the first driving electrode may be disposed to be spaced apart from each other.

The probe card may further include a first insulating layer between the probe substrate and the second driving electrode, a second insulating layer disposed between the diaphragm and the first wiring line and between the diaphragm and the second wiring line, a third insulating layer which is disposed on one surface of the second insulating layer and encloses the first wiring line and the second wiring line, and an elastic layer which is disposed on one surface of the third insulating layer and encloses the first pin electrode and the second pin electrode.

Each of the first wiring line and the second wiring line may include a first part disposed between the second insulating layer and the third insulating layer, a second part which passes through the third insulating layer and is connected to the first part, and a third part which is disposed on the one surface of the third insulating layer and connects the second part and the first pin electrode and the second pin electrode.

The third insulating layer may include an opening which overlaps the piezoelectric layer of the plurality of piezoelectric elements and exposes at least a part of the third part and a fluid filled or disposed in the opening may be further provided.

The piezoelectric layer of each of the plurality of piezoelectric elements may be configured to be deformed in a convex shape toward the diaphragm and the electrode unit by voltages of the first driving electrode and the second driving electrode and the diaphragm, the second insulating layer, and the fluid may be configured to be deformed along the convex shape of the piezoelectric layer.

An end portion of each of the plurality of pin electrodes may be configured so as to ascend or descend by the deformation of the piezoelectric layer, the diaphragm, the second insulating layer, and the fluid.

According to another aspect of the present disclosure, a method for inspecting a light emitting element includes contacting a probe card with a light emitting element array including a plurality of light emitting elements, sensing a Z-axis position of a plurality of electrodes of the plurality of light emitting elements, adjusting a Z-axis position of each of a plurality of pin electrodes of the probe card based on the Z-axis position, and inspecting an electrical characteristic of the plurality of light emitting elements by contacting the plurality of pin electrodes of the probe card with the plurality of electrodes of the plurality of light emitting elements, and the adjusting of a Z-axis position of each of a plurality of pin electrodes includes driving each of a plurality of piezoelectric elements disposed on the plurality of pin electrodes.

Each of the plurality of piezoelectric element may include a diaphragm disposed above each of the plurality of pin electrodes, a second driving electrode disposed on the diaphragm, a piezoelectric layer disposed on the second driving electrode, and a first driving electrode disposed on the piezoelectric layer, and the piezoelectric layer of each of the plurality of piezoelectric elements may overlap each of the plurality of pin electrodes.

In the driving of each of the plurality of piezoelectric elements, a shape of each of the plurality of piezoelectric elements may be deformed by an applied voltage and each of the plurality of piezoelectric elements may be configured to apply a pressure to the plurality of pin electrodes.

The probe card may include an elastic layer which encloses a part of the plurality of pin electrodes, and a fluid which is disposed between the diaphragm and the elastic layer and overlaps each of the plurality of pin electrodes, and in the driving of each of the plurality of piezoelectric elements, a shape of each of the plurality of piezoelectric elements may be deformed by an applied voltage and each of the plurality of piezoelectric elements may be configured to apply a pressure to the elastic layer, the fluid, and the plurality of pin electrodes.

According to another aspect of the present disclosure a probe card is presented. The probe card may comprise a probe substrate having a first surface and an opposite second surface; a piezoelectric element disposed on the first surface of the probe substrate, the piezoelectric element comprising a first driving electrode, a second driving electrode, a piezoelectric layer between the first driving electrode and the second driving electrode; an electrode unit adjacent to the piezoelectric element, the electrode unit comprising a first pin electrode and a second pin electrode extending outwardly from the probe card; a first wiring line electrically connected to the first pin electrode and extending laterally toward a first peripheral edge of the probe substrate; and a second wiring line electrically connected to the second pin electrode and extending laterally toward a second peripheral edge of the probe substrate opposite the first peripheral edge.

The first pin electrode and the second pin electrode may be vertically aligned with the piezoelectric element such that deformation of the piezoelectric element changes a height of the first pin electrode and the second pin electrode relative to the probe substrate.

The piezoelectric element may comprise a plurality of diaphragms adjacent to the second driving electrode.

The probe card may comprise a gap surrounding each diaphragm of the plurality of diaphragms, the gap being disposed between each diaphragm and adjacent diaphragms so as to separate the diaphragms from one another.

The probe card may comprise a fluid layer disposed vertically between the plurality of diaphragms and the first wiring line, and vertically between the plurality of diaphragms and the second wiring line.

The probe card may comprise an elastic layer adjacent to the fluid layer, the elastic layer including openings, wherein the first pin electrode and the second pin electrode of the electrode unit may extend through the openings in the elastic layer.

The first pin electrode and the second pin electrode may extend through the fluid layer toward the first wiring line and the second wiring line, respectively.

The plurality of diaphragms of the piezoelectric element may cover the first driving electrode completely in plan view.

The probe card may comprise: a first insulating layer enclosing the piezoelectric element; a second insulating layer enclosing the first and second wiring lines; and a third insulating layer enclosing the electrode unit, wherein the first and second wiring lines extend laterally between the second insulating layer and the third insulating layer.

Other detailed matters of the exemplary embodiments are included in the detailed description and the drawings.

According to the present disclosure, an electrical characteristic of a light emitting element array may be inspected.

According to the present disclosure, a height of a pin electrode of a probe card may be changed in consideration of a flatness of a wafer.

According to the present disclosure, a height of a pin electrode of a probe card may be changed in consideration of a Z-axis position of an electrode of a light emitting element.

According to the present disclosure, a height of a pin electrode may be changed while minimizing or reducing a damage of a pin electrode of a probe card.

The effects according to the present disclosure are not limited to the contents exemplified above, and more various effects are included in the present disclosure.

It is to be understood that both the foregoing general description and the following detailed description are exemplary and explanatory and are intended to provide further explanation of the inventive concepts as claimed.

### BRIEF DESCRIPTION OF THE SEVERAL VIEWS OF THE DRAWINGS

The above and other aspects, features and other advantages of the present disclosure will be more clearly understood from the following detailed description taken in conjunction with the accompanying drawings, in which:
FIG. 1 is a diagram of an inspection system of a light emitting element according to an exemplary embodiment of the present disclosure;
FIGS. 2 to 4 are cross-sectional views of a light emitting element array and a probe card according to an exemplary embodiment of the present disclosure;
FIGS. 5A to 5F are process diagrams for explaining a manufacturing method of a probe card according to an exemplary embodiment of the present disclosure;
FIGS. 6A to 6E are process diagrams for explaining a manufacturing method of a probe card according to an exemplary embodiment of the present disclosure; and
FIGS. 7A and 7B are process diagrams for explaining a manufacturing method of a probe card according to an exemplary embodiment of the present disclosure.

### DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

Like reference numerals generally denote like elements throughout the disclosure. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

The features of various embodiments of the present disclosure can be partially or entirely adhered to or combined with each other and can be interlocked and operated in technically various ways, and the embodiments can be carried out independently of or in association with each other.

Any implementation described herein as an "example" is not necessarily to be construed as preferred or advantageous over other implementations.

In describing a temporal relationship, when the temporal order is described as, for example, "after," "subsequent," "next," and "before," a case that is not continuous may be included unless a more limiting term, such as "just," "immediate(ly)," or "direct(ly)" is used.

Also, when an element or layer is "connected," "coupled," or "adhered" to another element or layer denotes that the element or layer can not only be directly connected or adhered to the other element or layer, but also be indirectly connected or adhered to the other element or layer with one or more intervening elements or layers "disposed," or "interposed" between the elements or layers, unless otherwise specified. It should be understood to mean that elements may be so disposed to directly contact each other, or may be so disposed without directly contacting each other.

As used herein, the term "connected" is intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The terms "coupled" and "in contact" should be interpreted in the same manner.

The expression of a first element, a second elements "and/or" a third element should be understood as one of the first, second and third elements or as any or all combinations of the first, second and third elements. By way of example, A, B and/or C can refer to only A; only B; only C; any or some combination of A, B, and C; or all of A, B, and C.

The term "at least one" should be understood as including any and all combinations of one or more of the associated listed items. For example, the meaning of "at least one of a first element, a second element, and a third element" encompasses the combination of all three listed elements, combinations of any two of the three elements, as well as each individual element, the first element, the second element, or the third element.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Hereinafter, exemplary embodiments of the present disclosure will be described in detail with reference to accompanying drawings.

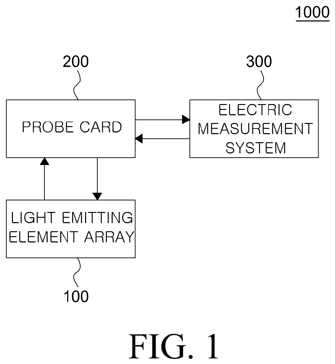

FIG. 1 is a diagram of an inspection system of a light emitting element according to an exemplary embodiment of the present disclosure.

Referring to FIG. 1, the inspection system 1000 is a system for inspecting an optical characteristic and/or an electrical characteristic of a light emitting element 120. The inspection system 1000 includes a light emitting element array 100, a probe card 200, and an electric measurement system 300.

The light emitting element array 100 includes a plurality of light emitting elements 120 disposed on one substrate. For example, the light emitting element array 100 may be configured by a plurality of light emitting elements 120 formed on a wafer.

The probe card 200 is an inspection device which inspects one or more of the plurality of light emitting elements 120. The probe card 200 may apply a signal to one or more or each of the plurality of light emitting elements 120 of the light emitting element array 100 and detect a signal output from the plurality of light emitting elements 120. The probe card 200 may connect an electrode, e.g. a pin electrode, to the plurality of light emitting elements 120 to inspect an electrical characteristic.

The electric measurement system 300 applies a driving signal to the probe card 200 and determines a state or a defect of the light emitting element 120 based on information measured by the probe card 200. The electric measurement system 300 is connected to the probe card 200 to inspect the electrical characteristic of the light emitting element 120. For example, the electric measurement system 300 applies a voltage to the pin electrode of the probe card 200 and/or receives information of the light emitting element 120 measured by the probe card 200 to analyze or determine characteristics of the light emitting element 120. The electric measurement system 300 identifies or determines one or more electrical characteristics of the light emitting element 120, for example, response or leakage current, to determine a short-circuit or an open failure of the light emitting element 120.

The electric measurement system 300 may include various configurations for driving the probe card 200. For example, the electric measurement system 300 may include a relay board 320, a printed circuit 310 or a flexible printed circuit 310, a 3D displacement sensor 340, and a source meter 330. The relay board 320 outputs a signal to the probe card 200 and/or receives a signal output from the probe card 200 to inspect or determine the characteristic of the light emitting element 120. The flexible printed circuit 310 may transmit a signal between the probe card 200 and the relay board 320. The 3D displacement sensor 340 may sense a Z-axis position of the first electrode 124 and the second electrode 125 of the light emitting element 120. The source meter 330 may generate a voltage to be applied to an electrode structure 230 (also referred to as 'an electrode unit 230') of the probe card 200. Further, the source meter 330 may generate a voltage to be applied to a piezoelectric unit or element 220 of the probe card 200 according to a sensing result of the 3D displacement sensor 340.

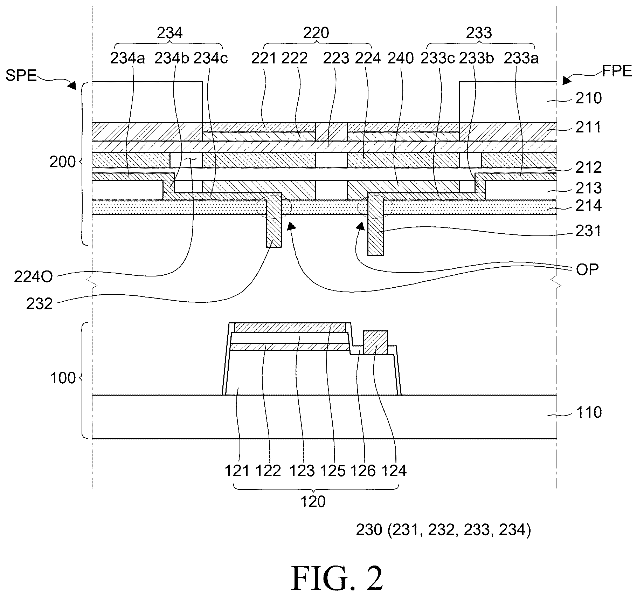

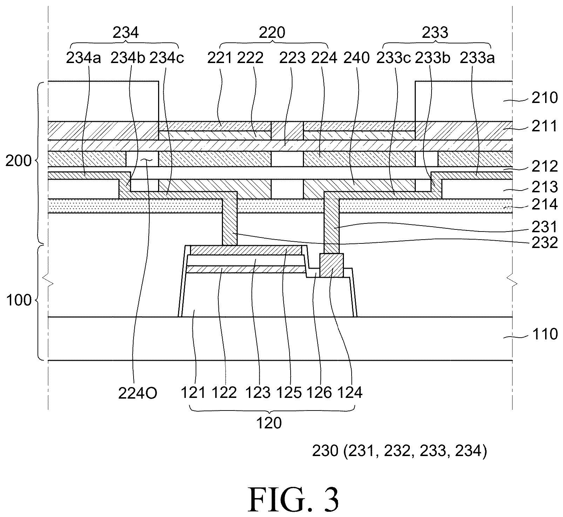

Hereinafter, the light emitting element array 100 and the probe card 200 will be described in detail with reference to FIGS. 2 to 4.

FIGS. 2 to 4 are cross-sectional views of a light emitting element array and a probe card according to an exemplary embodiment of the present disclosure. In FIGS. 2 to 4, for the convenience of description, only one light emitting element 120, among the plurality of light emitting elements 120 of the light emitting element array 100, is illustrated.

Referring to FIGS. 2 to 4, the light emitting element array 100 includes an array substrate 110 and a plurality of light emitting elements 120.

On the array substrate 110, the plurality of light emitting elements 120 is disposed. The array substrate 110 may be a wafer on which the light emitting element 120 is grown. The plurality of light emitting elements 120 on the array substrate 110 is transferred to the other place to be used after completing the inspection process.

The plurality of light emitting elements 120 is disposed on the array substrate 110. The plurality of light emitting elements 120 is semiconductor elements which emit light in an array by the current. The light emitting element 120 may be any one of a light-emitting diode (LED) or a micro light-emitting diode (micro LED), but the exemplary embodiments of the present disclosure are not limited thereto.

Each of the plurality of light emitting elements 120 includes a first semiconductor layer 121, an emission layer 122, a second semiconductor layer 123, a first electrode 124, a second electrode 125, and a protection film 126.

The first semiconductor layer 121 is disposed on the array substrate 110 and the second semiconductor layer 123 is disposed on the first semiconductor layer 121. Any one of the first semiconductor layer 121 and the second semiconductor layer 123 may be a semiconductor layer doped with an n-type impurity and the other may be a semiconductor layer doped with a p-type impurity. For example, the first semiconductor layer 121 and the second semiconductor layer 123 may be semiconductor layers doped with n-type or p-type impurities into a material such as gallium nitride (GaN), indium aluminum phosphide (InAlP), or gallium arsenide (GaAs).

The emission layer 122 is disposed between the first semiconductor layer 121 and the second semiconductor layer 123. The emission layer 122 may emit light based on a driving current supplied to the light emitting element 120. For example, the emission layer 122 may be formed by a single layer or a multi-quantum well (MQW) structure, and for example, may be formed of indium gallium nitride (InGaN) or gallium nitride (GaN), but is not limited thereto.

The first electrode 124 is disposed on a top surface of the first semiconductor layer 121 and the second electrode 125 is disposed on a top surface of the second semiconductor layer 123. Voltages are applied to the first electrode 124 and the second electrode 125, respectively, to drive the light emitting element 120.

The protection film 126 is disposed so as to enclose the first semiconductor layer 121, the emission layer 122, and the second semiconductor layer 123. The protection film 126 is an insulating film which is disposed so as to enclose at least a part of the first semiconductor layer 121, the emission layer 122, and the second semiconductor layer 123 to suppress the short-circuit defect.

The probe card 200 is an inspection device which inspects the plurality of light emitting elements 120. The probe card 200 includes a probe substrate 210, a first insulating layer 211, a second insulating layer 212, a third insulating layer 213, an elastic layer 214, a plurality of piezoelectric elements 220, and a plurality of electrode structure 230 (also referred to as 'a plurality of electrode units 230').

First, the probe substrate 210 is a member which supports other components or configurations of the probe card 200. The plurality of piezoelectric elements 220 and the plurality of electrode units 230 are formed on the probe substrate 210 to form the probe card 200. The probe substrate 210 may be disposed in an area between the plurality of piezoelectric elements 220.

The plurality of piezoelectric elements 220 is disposed on one surface of the probe substrate 210. The plurality of piezoelectric elements 220 is a mechanism or components or configurations for controlling a height of one or plurality of the pin electrodes. In the probe card 200 according to the exemplary embodiment of the present disclosure, the height of the plurality of pin electrodes may be adjusted using the converse piezoelectric effect of the plurality of piezoelectric elements 220.

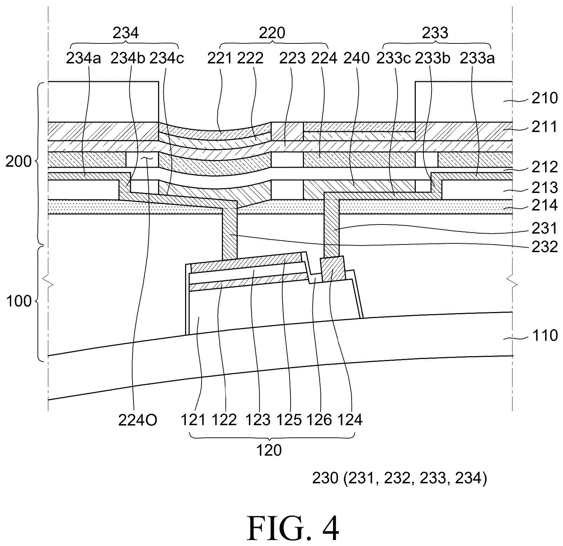

According to the converse piezoelectric effect, when a voltage is applied to the piezoelectric element 220, a stress is generated in the piezoelectric element 220, that is, the piezoelectric element 220 is contracted or expanded to generate vibration. Therefore, the voltage is applied to the piezoelectric element 220 to expand or contract the piezoelectric element 220 to control a height of the pin electrode below the piezoelectric element 220. For example, as illustrated in FIG. 4, when the piezoelectric element 220 expands to be downwardly convex, a pressure may be applied to a diaphragm 224 and a fluid 240 below the piezoelectric element 220 (i.e. in-between the piezoelectric element 220 and the corresponding or underlying pin electrode) and thus the corresponding or underlying pin electrode or the plurality of pin electrodes may also be affected thereby so that an end portion of the pin electrode may descend or move towards the light emitting element 120. If in a state as illustrated in FIG. 4, the piezoelectric element 220 is contracted again, the pressure applied to the diaphragm 224 and the fluid 240 below the piezoelectric element 220 may be reduced and the end portion of the pin electrode may ascend or move away from the light emitting element 120. Accordingly, a shape of the piezoelectric element 220 is deformed by adjusting a voltage applied to the piezoelectric element 220 to control a height of the plurality of pin electrodes, for example with respect to the light emitting element 120.

Each of the plurality of piezoelectric elements 220 includes a first driving electrode 221, a piezoelectric layer 222, a second driving electrode 223, and a diaphragm 224. In an example, a number of piezoelectric elements 220, for example of the piezoelectric layer 222 and/or of the diaphragm 224, may correspond to or may be same as or equal to a number of the electrode structures 230 for example to a number of the pair or plurality of pin electrodes 231, 232.

First, the first driving electrode 221 is disposed on one surface of the piezoelectric layer 222 and the second driving electrode 223 is disposed on an opposite surface of one surface of the piezoelectric layer 222. That is, the first driving electrode 221 and the second driving electrode 223 may be disposed on both surfaces of the piezoelectric layer 222. The first driving electrode 221 and the second driving electrode 223 are electrodes which apply a voltage to the piezoelectric layer 222.

In an exemplary embodiment, the first driving electrode 221 may apply different voltages to the plurality of piezoelectric layer 222 and the second driving electrode 223 may apply a common voltage to the plurality of piezoelectric layers 222. Therefore, the first driving electrode 221 may be separately formed in each of the plurality of piezoelectric layers 222 and the second driving electrode 223 may be commonly formed in the plurality of piezoelectric layers 222. However, a plurality of second driving electrodes 223 may be formed so as to correspond to the plurality of piezoelectric layers 222, but is not limited thereto.

When an electric field is applied to the piezoelectric layer 222, a stress is generated and in contrast, when a stress is applied to the piezoelectric layer 222, an electric field is generated. Therefore, when a voltage is applied from the first driving electrode 221 and the second driving electrode 223 to the piezoelectric layer 222, the piezoelectric layer 222 may be deformed. For example, the piezoelectric layer 222 may be formed of a PZT-based piezoelectric ceramic material configured by a solid solution of zirconate (PbZrO₃) and titanate (PbTiO₃).

The piezoelectric element 220 may be exposed from the probe substrate 210. For example, the probe substrate 210 may be disposed in an area between the plurality of piezoelectric elements 220 and the first driving electrode 221 of the piezoelectric element 220 may be exposed from the probe substrate 210. Accordingly, a part of the probe substrate 210 which covers the piezoelectric element 220 is removed so that when the piezoelectric element 220 is deformed, interference between the probe substrate 210 and the piezoelectric element 220 may be minimized or reduced and the piezoelectric element 220 may be more easily deformed.

Next, the first insulating layer 211 is disposed on one surface of the probe card 200 and is disposed so as to enclose side surfaces of the first driving electrode 221 and the piezoelectric layer 222 of the piezoelectric element 220. The first insulating layer 211 may be disposed in a remaining area in which the first driving electrode 221 and the piezoelectric layer 222 of the piezoelectric element 220 are not disposed. For example, the first insulating layer 211 is disposed between the second driving electrode 223 and the probe substrate 210 and may be disposed so as to enclose the first driving electrodes 221 and the piezoelectric layers 222 of the plurality of piezoelectric elements 220.

A plurality of diaphragms 224 is disposed on one surface of the second driving electrode 223. Each of the plurality of diaphragms 224 may be disposed so as to correspond to each of the plurality of piezoelectric layers 222. The plurality of diaphragms 224 may be disposed to be spaced apart from each other. For example, a gap 224O may be formed between a diaphragm 224 overlapping one piezoelectric layer 222 and a diaphragm 224 overlapping the other piezoelectric layer 222. The gap 224O may be disposed along a periphery of the diaphragm 224 and a periphery of the first driving electrode 221. Therefore, when one diaphragm 224 is deformed, the other adjacent diaphragm 224 may not be affected.

Next, the second insulating layer 212 is disposed on one surface of the plurality of diaphragms 224. The second insulating layer 212 may be disposed so as to cover all one surfaces of the plurality of diaphragms 224 and the gaps 224O between the plurality of diaphragms 224.

The plurality of electrode units 230 is disposed on one surface of the second insulating layer 212. The plurality of electrode units 230 is configurations for inspecting the light emitting element 120 and may inspect the defect of the light emitting element 120 by applying a voltage to each of the first electrode 124 and the second electrode 125 of the light emitting element 120. Each of the pair or the plurality (a number which may be greater than two) of electrode units 230 includes a first pin electrode 231, a second pin electrode 232, a first wiring line 233, and a second wiring line 234.

First, the first wiring line 233 and the second wiring line 234 are disposed on one surface of the second insulating layer 212. The first wiring line 233 is connected to the first pin electrode 231 and the second wiring line 234 is connected to the second pin electrode 232. The first wiring line 233 and the second wiring line 234 are connected to the electric measurement system 300 to transmit the voltage to the first pin electrode 231 and the second pin electrode 232. For example, the first wiring line 233 and the second wiring line 234 extend toward a side surface of the probe card 200 to be electrically connected to the flexible printed circuit 310 bonded to the side surface of the probe card 200 to exchange signals with the electric measurement system 300.

The first wiring line 233 and the second wiring line 234 may be formed by first parts 233a and 234a, second parts 233b and 234b, and third parts 233c and 234c. The first parts 233a and 234a of the first wiring line 233 and the second wiring line 234 are disposed on one surface of the second insulating layer 212. The second parts 233b and 234b of the first wiring line 233 and the second wiring line 234 pass through the third insulating layer 213 and both ends of the second parts 233b and 234b may be connected to the first parts 233a and 234a and the third parts 233c and 234c. The third parts 233c and 234c of the first wiring line 233 and the second wiring line 234 are disposed on one surface of the third insulating layer 213 and may connect the second parts 233b and 234b and the first pin electrode 231 and the second pin electrode 232.

The first pin electrode 231 and the second pin electrode 232 are electrodes which apply a voltage to one of the plurality of light emitting elements 120. When the probe card 200 is in contact with the light emitting element array 100, the first pin electrode 231 may be in contact with the first electrode 124 of the light emitting element 120 and the second pin electrode 232 may be in contact with the second electrode 125 of the light emitting element 120. Accordingly, the voltage is applied to each of the first electrode 124 and the second electrode 125 of the light emitting element 120 using the first pin electrode 231 and the second pin electrode 232 to inspect the light emitting element 120.

The first pin electrode 231 is disposed on the first wiring line 233 and the second pin electrode 232 is disposed on the second wiring line 234. The first pin electrode 231 may be connected to the third parts 233c and 234c of the first wiring line 233 and the second pin electrode 232 may be connected to the third parts 233c and 234c of the second wiring line 234. The first pin electrode 231 and the second pin electrode 232 may be disposed to protrude to the outside of the elastic layer 214. At this time, the lengths (e.g. protruding length) of the first pin electrode 231 and the second pin electrode 232 may be configured to be different from each other in consideration of heights of the first electrode 124 and the second electrode 125 of the light emitting element 120. For example, when a top surface of the first electrode 124 is located to be lower than a top surface of the second electrode 125, a length of the first pin electrode 231 which is configured to be in contact or which functions to be in contact with the first electrode 124 may be formed to be longer than a length of the second pin electrode 232 which is in contact with the second electrode 125. In an example the heights/lengths/ protruding lengths (as mentioned herein or in the present disclosure) may be measured with respect to the elastic layer 214 or with respect to a surface of the elastic layer 214 which forms an external appearance of the probe card or with respect to the probe substrate or with respect to a surface of the probe substrate, for example with respect to a surface of the probe substrate which forms an external appearance of the probe card or with respect to a surface of the probe substrate opposite to a surface of the probe substrate which forms an external appearance of the probe card (i.e. with respect to a surface opposite to an external surface of the probe substrate).

Next, the third insulating layer 213 is disposed on one surface of the second insulating layer 212. The third insulating layer 213 may be disposed on one surface of the second insulating layer 212 so as to cover the first parts 233a and 234a and the second parts 233b and 234b of the first wiring line 233 and the second wiring line 234. At this time, the third insulating layer 213 may include a plurality of openings overlapping the plurality of piezoelectric layers 222.

The fluid 240 is disposed in the plurality of openings of the third insulating layer 213. The fluid 240 may be formed of any one of gas or liquid materials, such as air or oil. The fluid 240 is filled in the opening of the third insulating layer 213 to transmit the pressure from the deformed piezoelectric element 220 to the first pin electrode 231 and the second pin electrode 232.

For example, as illustrated in FIG. 4, when the diaphragm 224 and the second insulating layer 212 are deformed to be downwardly convex by the pressure from the piezoelectric element 220, the fluid 240 is also affected by the pressure from the piezoelectric element 220, the diaphragm 224, and the second insulating layer 212 to push the first pin electrode 231, the second pin electrode 232 and the third parts 233c and 234c. The pressure may be uniformly transmitted to all the first pin electrode 231, the second pin electrode 232 and the third parts 233c and 234c through the fluid 240. Accordingly, the fluid 240 is disposed between the diaphragm 224 and the electrode unit 230 to suppress physical contact of the diaphragm 224 and the electrode unit 230 and minimize the damage of the electrode unit 230 according to the physical contact of the diaphragm 224 and the electrode unit 230.

The elastic layer 214 is disposed so as to cover the electrode unit 230 and the fluid 240. The elastic layer 214 may be disposed so as to cover all one surface of the third insulating layer 213, the first wiring line 233, the second wiring line 234, and the fluid 240 and the first pin electrode 231 and the second pin electrode 232 are connected to the first wiring line 233 and the second wiring line 234 passing through the elastic layer 214. The elastic layer 214 is disposed so as to enclose at least a part of the first pin electrode 231 and the second pin electrode 232 to disperse the force which is applied to the first pin electrode 231 and the second pin electrode 232 and reduce the damage of the first pin electrode 231 and the second pin electrode 232.

In an exemplary embodiment, the array substrate 110 may be a wafer on which the light emitting element 120 is grown and a sapphire substrate may be used as a wafer. An epi layer is grown on the wafer to form the plurality of light emitting elements 120. At this time, there is a difference in coefficients of thermal expansion between a wafer and the epi layer formed on the wafer so that tensile stress may be generated and the wafer may be bent.

Referring to FIG. 4, when the wafer is bent, heights of the first electrode 124 and/or the second electrode 125 of each of the plurality of light emitting elements 120 disposed on the wafer may be different, for example with respect to the heights in unbent or planar or horizontal state of the wafer. For example, when the wafer is bent and thus has an inclined surface (also referred to as inclined surface part or region) and a horizontal surface (also referred to as horizontal surface part or region), an angle of the light emitting element 120 disposed on the inclined surface and an angle of the light emitting element 120 disposed on the horizontal surface are different so that the heights of the first electrode 124 and the second electrode 125 may also be different, for example with respect to the heights in unbent or planar or horizontal state of the wafer.

Therefore, in the probe card 200 according to the exemplary embodiment of the present disclosure, heights of the first pin electrode 231 and the second pin electrode 232, that is, a Z-axis position may vary, in consideration of the Z-axis position of the first electrode 124 and the second electrode 125 of the light emitting element 120. The electric measurement system 300 may sense the Z-axis position of the first electrode 124 and the second electrode 125 of the light emitting element 120 using the 3D displacement sensor 340. The electric measurement system 300 may calculate a displacement variation of the Z-axis position of the first pin electrode 231 and the second pin electrode 232 by reflecting the Z-axis position of the first electrode 124 and the second electrode 125. The electric measurement system 300 applies the voltage based on the displacement variation to the first driving electrode 221 and the second driving electrode 223 of the piezoelectric element 220 to deform the piezoelectric element 220. Therefore, the heights of the first pin electrode 231 and the second pin electrode 232 may be separately controlled in accordance with the deformation of the piezoelectric element 220. Accordingly, in the probe card 200 according to the exemplary embodiment of the present disclosure, heights of the first pin electrode 231 and the second pin electrode 232 may be changeable to easily inspect the plurality of light emitting elements 120 without being restricted to the Z-axis position deviation of the first electrode 124 and the second electrode 125 of the light emitting element 120.

In an exemplary embodiment, in the drawings, for the convenience of description, only one light emitting element 120, one piezoelectric element 220, and one electrode unit 230 are illustrated. However, a plurality of light emitting elements 120 is disposed on an array substrate 110 and a plurality of piezoelectric elements 220 and a plurality of electrode units 230 corresponding to the plurality of light emitting elements 120, respectively, may be disposed in the probe card 200. Accordingly, the plurality of light emitting elements 120 may be simultaneously inspected using the probe card 200 including the plurality of piezoelectric elements 220 and the plurality of electrode units 230.

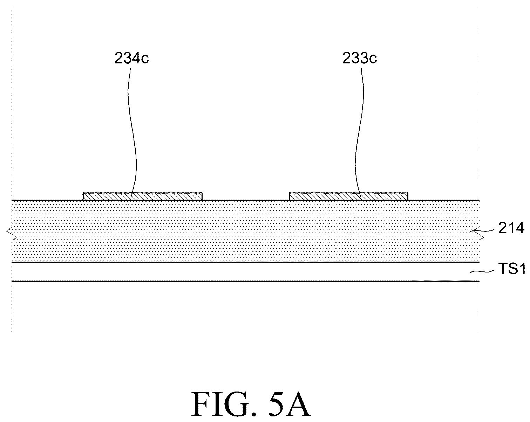

Hereinafter, a manufacturing method of a probe card 200 according to an exemplary embodiment of the present disclosure will be described with reference to FIGS. 5A to 7B.

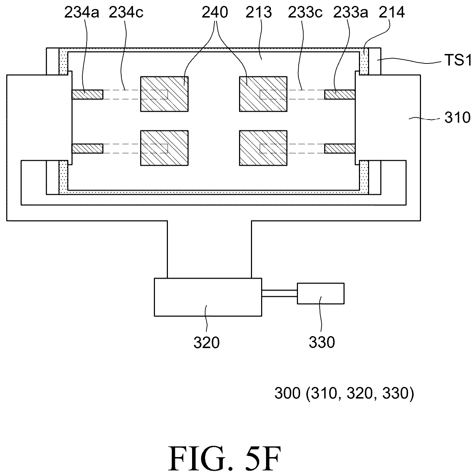

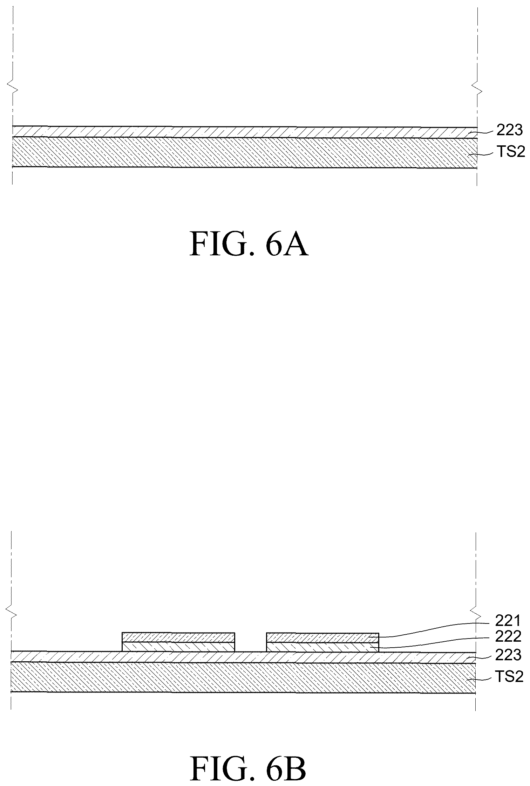

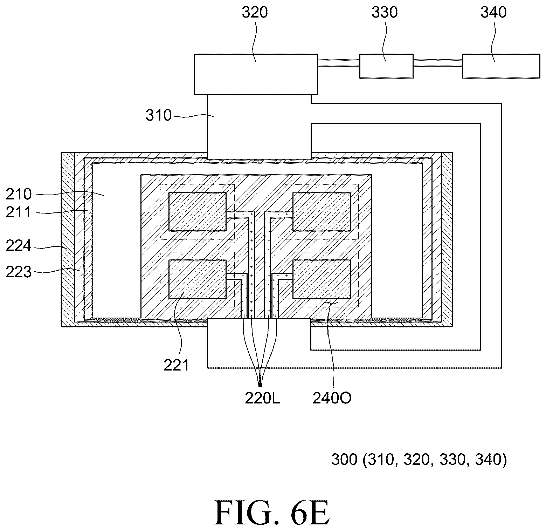

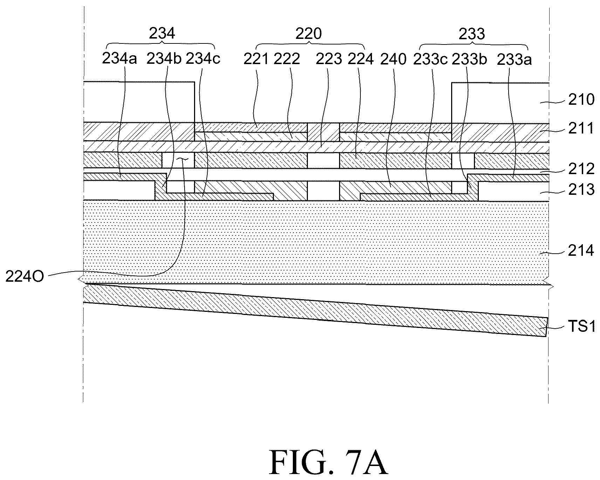

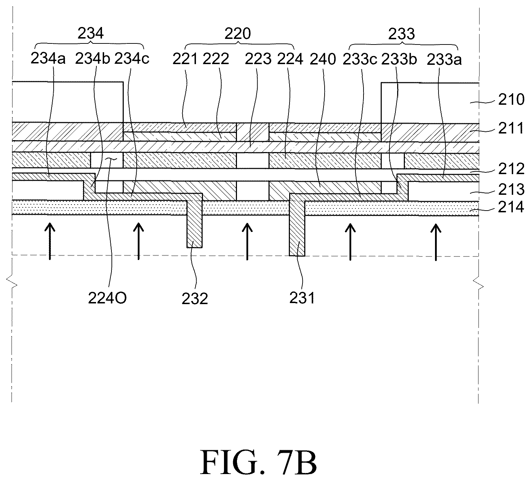

FIGS. 5A to 5F are process diagrams for explaining a manufacturing method of a probe card according to an exemplary embodiment of the present disclosure. FIGS. 6A to 6E are process diagrams for explaining a manufacturing method of a probe card according to an exemplary embodiment of the present disclosure. FIGS. 7A and 7B are process diagrams for explaining a manufacturing method of a probe card according to an exemplary embodiment of the present disclosure. Specifically, FIGS. 5A to 5E are cross-sectional views for explaining a manufacturing method of an electrode unit 230 and FIG. 5F is a plan view for explaining a manufacturing method of an electrode unit 230. FIGS. 6A to 6D are cross-sectional views for explaining a manufacturing method of a piezoelectric unit 220 or element 220 and FIG. 6E is a plan view for explaining a manufacturing method of a piezoelectric element 220. FIGS. 7A and 7B are cross-sectional views for explaining a manufacturing method of a first pin electrode 231 and a second pin electrode 232 by bonding an electrode unit 230 and the piezoelectric element 220. For the convenience of description, in FIG. 5F, the second insulating layer 212 is not illustrated.

Referring to FIGS. 5A to 5F, a plurality of electrode units 230 is formed on a first temporary substrate TS1.

First, referring to FIG. 5A, an elastic layer 214 is formed on the first temporary substrate TS1 and third parts 233c and 234c of a first wiring line 233 and a second wiring line 234 are formed on the elastic layer 214. The first temporary substrate TS1 is temporarily used for the manufacturing process of the electrode unit 230 and may be removed in a subsequent process. A thickness of the elastic layer 214 is formed to be larger than a thickness of a final structure of the probe card 200 and may be processed to be thin after completing the formation of the first pin electrode 231 and the second pin electrode 232.

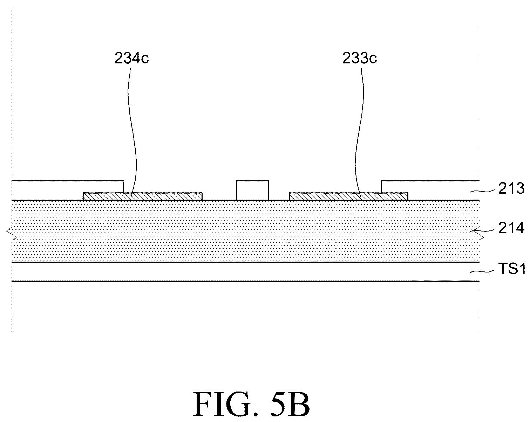

Referring to FIG. 5B, the third insulating layer 213 is formed on the third parts 233c and 234c of the first wiring line 233 and the second wiring line 234. At this time, a part of the third insulating layer 213 which covers the third parts 233c and 234c is removed to form a plurality of openings so as to allow the fluid 240 to be filled on the third parts 233c and 234c of the first wiring line 233 and the second wiring line 234.

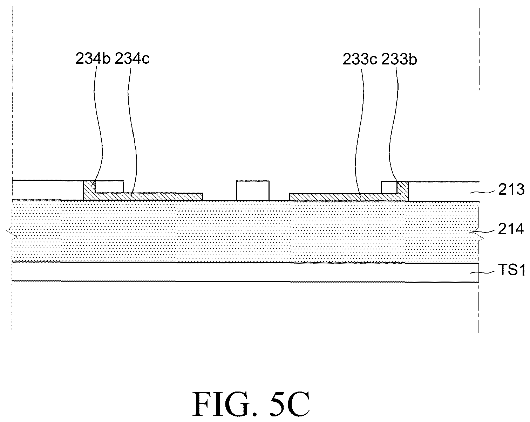

Referring to FIG. 5C, second parts 233b and 234b of the first wiring line 233 and the second wiring line 234 are formed. The second parts 233b and 234b may be formed so as to pass through the third insulating layer 213. The second parts 233b and 234b may be connected to the third parts 233c and 234c while passing through the third insulating layer 213.

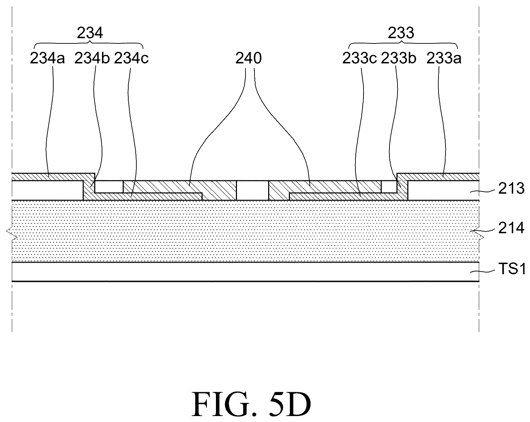

Referring to FIG. 5D, first parts 233a and 234a of the first wiring line 233 and the second wiring line 234 are formed and are filled with the fluid 240. The first parts 233a and 234a may be formed on a surface of the third insulating layer 213 and may be connected to the second parts 233b and 234b. Accordingly, the formation process of the first wiring line 233 and the second wiring line 234 formed by the first parts 233a and 234a, the second parts 233b and 234b, and the third parts 233c and 234c may be completed. The fluid 240 may be filled in each of the plurality of openings of the third insulating layer 213.

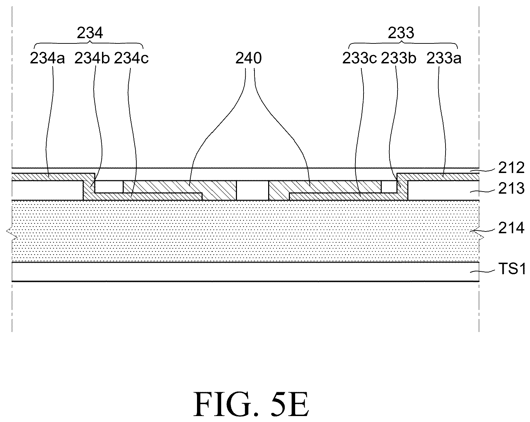

Referring to FIG. 5E, the second insulating layer 212 is formed on the third insulating layer 213. The second insulating layer 212 is disposed so as to cover all the first wiring line 233, the second wiring line 234, and the fluid 240 to protect the first wiring line 233, the second wiring line 234, and the fluid 240.

Referring to FIG. 5F, the first wiring line 233 and the second wiring line 234 are connected to the electric measurement system 300. For example, the first parts 233a and 234a of the first wiring line 233 and the second wiring line 234 may extend toward the side surface of the probe card 200. The flexible printed circuit 310 of the electric measurement system 300 is bonded to the side surface of the probe card 200 to connect the flexible printed circuit 310 of the electric measurement system 300 and the first wiring line 233 and the second wiring line 234. Accordingly, the first wiring line 233 and the second wiring line 234 may receive a signal from a relay board 320 and a source meter 330 through the flexible printed circuit 310 and transmit the signal to the first pin electrode 231 and the second pin electrode 232.

Next, referring to FIGS. 6A to 6E, a plurality of piezoelectric elements 220 is formed on a second temporary substrate TS2.

First, referring to FIG. 6A, a second driving electrode 223 is formed on the second temporary substrate TS2. At this time, the second driving electrode 223 of each of the plurality of piezoelectric elements 220 applies the same common voltage to the piezoelectric layer 222 so that one second driving electrode 223 may be formed in the plurality of piezoelectric elements 220.

Referring to FIG. 6B, the plurality of piezoelectric layers 222 and the plurality of first driving electrodes 221 are formed on the second driving electrode 223. The plurality of piezoelectric layers 222 may be formed on the second driving electrode 223 and the first driving electrode 221 may be formed above each of the plurality of piezoelectric layers 222.

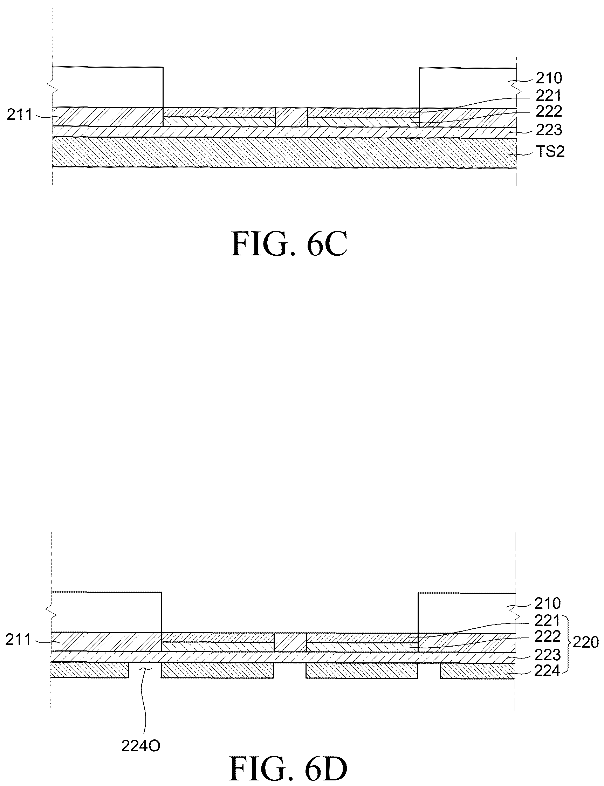

Referring to FIG. 6C, a first insulating layer 211 which encloses the plurality of piezoelectric layers 222 and the plurality of first driving electrodes 221 is formed. The first insulating layer 211 may be formed so as to cover the second driving electrode 223. The first insulating layer 211 may enclose a side surface of each of the plurality of piezoelectric layers 222 and the plurality of first driving electrodes 221. Top surfaces of the plurality of first driving electrodes 221 may be exposed from the first insulating layer 211.

Next, a probe substrate 210 is formed on the first insulating layer 211. The probe substrate 210 may be partially disposed only in an area between the plurality of piezoelectric layers 222.

Referring to FIG. 6D, a plurality of diaphragms 224 is formed from the second temporary substrate TS2. A part of the second temporary substrate TS2 corresponding to the area between the plurality of piezoelectric layers 222 is removed to form a plurality of diaphragms 224 which corresponds to the plurality of piezoelectric layers 222 one to one. Further, for the purpose of flexible deformation of the diaphragm 224, a thickness of the second temporary substrate TS2, that is, a thickness of the diaphragm 224 may be processed to be thin.

Referring to FIG. 6E, the plurality of piezoelectric elements 220 is connected to the electric measurement system 300. For example, the first driving electrode 221 is disposed to extend toward one side surface of the probe card 200 and the flexible printed circuit 310 of the electric measurement system 300 is bonded to one side surface of the probe card 200 to connect the first driving electrode 221 and the electric measurement system 300.

A connection line 220L which extends from each of the plurality of second driving electrodes 223 may be disposed on the first insulating layer 211. The connection line 220L may extend toward the other side surface of the probe card 200 and may be connected to the flexible printed circuit 310 bonded to the other side surface of the probe card 200.

Accordingly, the first driving electrode 221 and the second driving electrode 223 of each of the plurality of piezoelectric elements 220 may be driven with signals applied from the relay board 320 and the source meter 330 through the flexible printed circuit 310. At this time, signals applied to the first driving electrode 221 and the second driving electrode 223 may vary depending on the Z-axis position of the first electrode 124 and the second electrode 125 of the light emitting element 120 sensed by the 3D displacement sensor 340.

Next, referring to FIG. 7A, the plurality of electrode units 230 and the plurality of piezoelectric elements 220 are bonded and the first temporary substrate TS1 is removed. For example, the plurality of electrode units 230 and the plurality of piezoelectric elements 220 may be bonded so as to place the plurality of diaphragms 224 on the second insulating layer 212 which covers the plurality of electrode units 230. Next, the first temporary substrate TS1 is removed to expose the elastic layer 214.

Referring to FIG. 7B, the first pin electrode 231 and the second pin electrode 232 are formed. A hole which overlaps the first parts 233a and 234a of the first wiring line 233 and the second wiring line 234 is formed in the elastic layer 214 and the plating process is performed in the hole to form the first pin electrode 231 and the second pin electrode 232. Accordingly, the first pin electrode 231 and the second pin electrode 232 which are connected to the first wiring line 233 and the second wiring line 234 may be formed.

Finally, the thickness of the elastic layer 214 is processed to be thin to expose the first pin electrode 231 and the second pin electrode 232 from the elastic layer 214.

Accordingly, in the probe card 200 according to the exemplary embodiment of the present disclosure, the plurality of piezoelectric elements 220 is bonded on the plurality of electrode units 230 to manufacture the probe card 200 including the first pin electrode 231 and the second pin electrode 232 having a variable or different height. For example, the first wiring line 233 and the second wiring line 234 of the electrode unit 230 and the fluid 240 may be formed on the first temporary substrate TS1 and the plurality of piezoelectric elements 220 may be formed on the second temporary substrate TS2. After forming the plurality of diaphragms 224 by patterning the second temporary substrate TS2, the plurality of diaphragms 224 and the plurality of piezoelectric elements 220 may be bonded onto the first wiring line 233 and the second wiring line 234. Finally, the first temporary substrate TS1 is removed and the plating process is performed on the hole of the elastic layer 214 to form the first pin electrode 231 and the second pin electrode 232, thereby manufacturing the probe card 200 including both the electrode unit 230 and the piezoelectric element 220. Therefore, the probe card 200 may be formed which is easily contacted with the first electrode 124 and the second electrode 125 of the plurality of light emitting elements 120 without being restricted to the flatness of the array substrate 110 and an inspection accuracy of the plurality of light emitting elements 120 may be improved.

The exemplary embodiments of the present disclosure can also be described as follows:

A probe card may include a probe substrate 210 having a first surface and an opposite second surface. A piezoelectric element 220 may be disposed on the first surface of the probe substrate 210. The piezoelectric element 220 may include a first driving electrode 221, a second driving electrode 223, and a piezoelectric layer 222 positioned between the first driving electrode 221 and the second driving electrode 223. An electrode unit 230 may be located adjacent to the piezoelectric element 220 and may include a first pin electrode 231 and a second pin electrode 232 extending outwardly from the probe card. A first wiring line 233 may be electrically connected to the first pin electrode 231 and may extend laterally toward a first peripheral edge FPE of the probe substrate 210. A second wiring line 234 may be electrically connected to the second pin electrode 232 and may extend laterally toward a second peripheral edge SPE of the probe substrate 210 opposite the first peripheral edge FPE.

As further shown in FIG. 4, the first pin electrode and the second pin electrode may be vertically aligned with the piezoelectric element such that deformation of the piezoelectric element changes a height of the first pin electrode 231 and the second pin electrode 232 relative to the probe substrate 210. In some embodiments, deformation of the piezoelectric element along a vertical axis may cause the first and second pin electrodes to move upwardly or downwardly to compensate for variations in electrode height on a semiconductor wafer.

Referring again to FIG. 2, the piezoelectric element 220 may further include a plurality of diaphragms 224 disposed adjacent to the second driving electrode 223.

A gap 224O may surround each diaphragm of the plurality of diaphragms 224 such that the gap 224O is disposed between each diaphragm and adjacent diaphragms to separate the diaphragms from one another. The gap 224O may be formed as a void or trench region between diaphragms in plan view.

A fluid layer 240 may be disposed vertically between the plurality of diaphragms and the first wiring line 233, and also vertically between the plurality of diaphragms and the second wiring line 234. The fluid layer 240 may transmit pressure from the diaphragms to the wiring lines and may facilitate smooth vertical displacement of the pin electrodes.

In certain embodiments, an elastic layer 214 may be positioned adjacent to the fluid layer 240. The elastic layer 214 may include one or more openings OP, and the first pin electrode 231 and the second pin electrode 232 of the electrode unit may extend through the openings OP in the elastic layer 214.

As further shown in FIG. 2, the first pin electrode 231 and the second pin electrode 232 may also extend through the fluid layer 240 toward the first wiring line 233 and the second wiring line 234, respectively.

In some embodiments, the plurality of diaphragms 224 of the piezoelectric element 220 may completely cover the first driving electrode 221 in plan view. In this manner, the first driving electrode 221 may be fully enclosed beneath the plurality of diaphragms 224 when viewed from above the probe card.

The probe card may further include a first insulating layer enclosing the piezoelectric element, a second insulating layer enclosing the first wiring line and the second wiring line, and a third insulating layer enclosing the electrode unit. The first and second wiring lines may extend laterally between the second insulating layer and the third insulating layer to electrically connect the pin electrodes to external circuitry located at peripheral edges of the probe card.

The exemplary embodiments of the present disclosure can further be described as follows:

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. All the technical concepts in the equivalent scope of the present disclosure should be construed as falling within the scope of the present disclosure.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A probe card (200) comprising:
a probe substrate (210);
a piezoelectric element (220), disposed at one surface of the probe substrate (210), and comprising a piezoelectric layer (222) configured to deform in accordance with a voltage applied to the piezoelectric element (220); and
an electrode unit (230), disposed on the piezoelectric element (200), and including a plurality of pin electrodes (231, 232), wherein each pin electrode (231, 232) has a corresponding piezoelectric layer (222) and is moveable based on a deformation of the corresponding piezoelectric layer (222) to vary a protruding height of the pin electrode (231, 232).

2. The probe card (200) of claim 1, wherein:
the piezoelectric element (220) is a plurality of the piezoelectric elements (220);
the electrode unit (230) is a plurality of the electrode units (230); and
the piezoelectric elements are disposed so as to correspond to the pin electrodes in one to one correspondence.^

3. The probe card according to any one of the preceding claims, wherein each of the plurality of electrode units (230) further includes:
a first wiring line (233) electrically connected to a first pin electrode (231) of the plurality of pin electrodes, preferably the first wiring line (233) extends laterally toward a first peripheral edge of the probe substrate; and
a second wiring line (234) electrically connected to a second pin electrode (232) of the plurality of pin electrodes, preferably the second wiring line (234) extends laterally toward a second peripheral edge of the probe substrate; and
wherein each of the first pin electrode (231) and the second pin electrode (232) overlaps a different piezoelectric element and/or a different piezoelectric layer (222) of the plurality of piezoelectric elements.

4. The probe card according to any one of the preceding claims, wherein each piezoelectric element includes: a first driving electrode (221) disposed at one surface of the probe substrate; the piezoelectric layer (222) disposed on the first driving electrode; a second driving electrode (223) disposed on the piezoelectric layer; and a diaphragm (224) disposed on the second driving electrode; preferably the probe substrate and the first driving electrode are disposed to be spaced apart from each other.

5. The probe card according to claim 4 when depending on claim 3, further comprising:
a first insulating layer (211) between the probe substrate and the second driving electrode;
a second insulating layer (212) disposed between the diaphragm and the first wiring line and between the diaphragm and the second wiring line;
a third insulating layer (213) disposed on one surface of the second insulating layer and enclosing the first wiring line and the second wiring line; and
an elastic layer (214) disposed on one surface of the third insulating layer and enclosing the first pin electrode and the second pin electrode.

6. The probe card of claim 5, wherein the elastic layer comprises openings, and the first pin electrode and the second pin electrode of the electrode unit extend through the openings in the elastic layer.

7. The probe card according to claim 5 or 6, wherein each of the first wiring line and/or the second wiring line includes:
a first part (233a, 234a) disposed between the second insulating layer and the third insulating layer;
a second part (233b, 234b) passing through the third insulating layer and is connected to the first part; and
a third part (233c, 234c) disposed on the one surface of the third insulating layer, and
wherein the third part of the first wiring line connects the second part of the first wiring line and the first pin electrode, and the third part of the second wiring line connects the second part of the second wiring line and the second pin electrode.

8. The probe card according to claim 7, wherein the third insulating layer includes an opening which overlaps the piezoelectric layer of the plurality of piezoelectric elements and exposes at least a part of the third part, and
wherein a fluid (240) is disposed in the opening.

9. The probe card of claim 8, wherein the first pin electrode and the second pin electrode extend through the fluid layer toward the first wiring line and the second wiring line, respectively.

10. The probe card according to claim 9, wherein the piezoelectric layer of the piezoelectric element is deformable into a convex shape toward the diaphragm and the electrode unit in response to voltages applied to the first driving electrode and the second driving electrode, and the diaphragm, the second insulating layer, and the fluid deform along with the convex shape of the piezoelectric layer.

11. The probe card according to claim 10, wherein an end portion of each of the plurality of pin electrodes is configured to move upward or downward as the piezoelectric layer, the diaphragm, the second insulating layer, and the fluid deform.

12. The probe card according to any one of the preceding claims,
wherein the pin electrodes of the plurality of pin electrodes extending outwardly from the probe card extend to different heights in a default state of the probe card in absence of application of a voltage to the piezoelectric element (220).

13. The probe card of claim 12, wherein the first pin electrode and the second pin electrode are vertically aligned with the piezoelectric element such that deformation of the piezoelectric element changes a height of the first pin electrode and the second pin electrode relative to the probe substrate.

14. The probe card of any one of the preceding claims when depending on claim 4, wherein the diaphragm of the piezoelectric element covers the first driving electrode completely in plan view.

15. A method of manufacturing a probe card according to any one of the preceding claims, the method comprising:
forming a part of the electrode unit (230);
forming the piezoelectric element (220), wherein the piezoelectric element (220) and the part of the electrode unit (230) are formed separately or independent of each other;
assembling with each other the part of the electrode unit (230) so formed and the piezoelectric element (220) so formed; and
forming the pin electrodes (231, 232) on the part of the electrode unit (230) so assembled.
